# EUROPEAN PATENT APPLICATION

(11) **EP 4 170 717 A1**
(43) Date of publication of application: **26.04.2023**
(21) Application number: 20942098.3
(22) Date of filing: 20.07.2020
(51) Int. Cl.: H01L 27/12, H01L 27/32

(54) **ARRAY SUBSTRATE AND MANUFACTURING METHOD THEREFOR**

(30) Priority: 23.06.2020 CN 202010580236
(71) Applicant: Wuhan China Star Optoelectronics Semiconductor Display Technology Co., Ltd., Wuhan, Hubei 430079 (CN)
(72) Inventor: GONG, Jixiang, Wuhan, Hubei 430079 (CN); ZHANG, Yixian, Wuhan, Hubei 430079 (CN); XIANYU, Wenxu, Wuhan, Hubei 430079 (CN)
(74) Representative: Murgitroyd & Company
(86) International application number: PCT/CN2020/103098
(87) International publication number: WO 2021/258458

(57) **Abstract**

Provided are an array substrate and a manufacturing method therefor. The array substrate comprises a substrate, a first TFT and a second TFT, wherein the first TFT comprises a first active layer, a first gate insulating layer disposed on the first active layer, and a first gate electrode disposed on the first gate insulating layer; the second TFT comprises a second active layer disposed on the first gate insulating layer; and the first gate electrode and the second active layer are made of the same material, and are of an integrally formed structure.

## Description

### FIELD OF INVENTION

The present disclosure relates to the field of display technology, and more particularly, to an array substrate and a manufacturing method thereof.

### BACKGROUND OF INVENTION

In current display technology field, liquid crystal displays (LCDs) and organic light emitting diode (OLED) displays have been widely used in daily life such as mobile phones or televisions.

### SUMMARY OF INVENTION

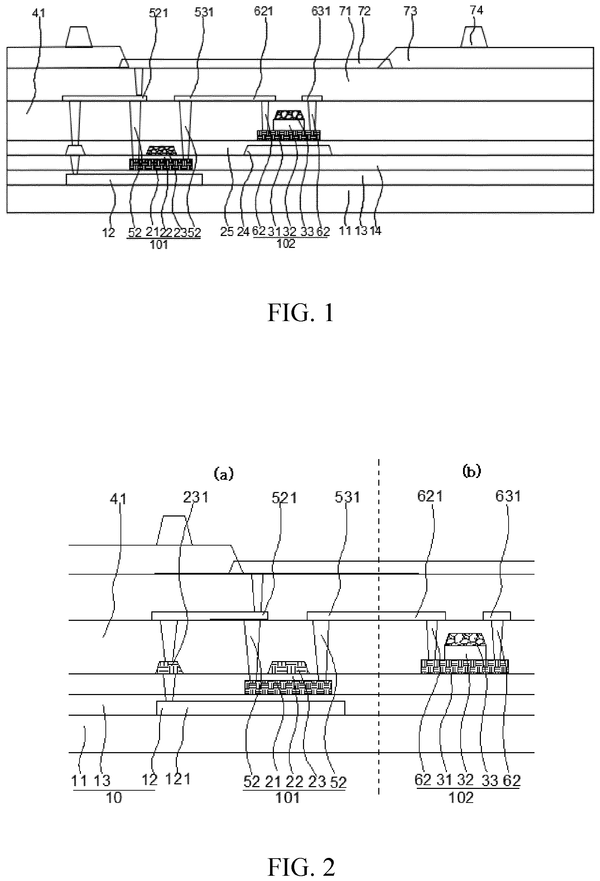

At present, most OLED displays use low temperature poly-silicon (LTPS) thin film transistor (TFT) panel technology. In the past few years of improvement, although LTPS display panels are popular in the market, they have disadvantages of higher production cost and greater power consumption. Hence, technicians have developed low temperature polycrystalline oxide (LTPO) display panel technology, that is, the LTPO display panels are obtained by combining the LTPS display panel technology and oxide display panel technology. A TFT portion of a pixel region circuit of the LTPO display panel is divided into two types, one is a LTPS TFT mainly configured to drive the TFT, the other is an indium gallium zinc oxide (IGZO) TFT mainly configured to reduce a leakage current. As shown in FIG. 1, FIG. 1 is an array substrate structure of the current LTPO display panels that comprises a first TFT 101 of the LTPS and a second TFT 102 of the oxide. Because the first TFT and the second TFT are not in a same layer which are both top gate structures, wherein a first active layer 21, a first gate insulating layer 22, a first gate 23, an insulating layer 25, a second active layer 31, a second gate insulating layer 32, and a second gate 33 are respectively formed by different photomasks. Therefore, a number of film layers is greater, and a number of the photomasks and processes required are greater.

An embodiment of the present disclosure provides an array substrate and a manufacturing method thereof to solve a problem that current low temperature polycrystalline oxide (LTPO) array substrates have a greater number of photomasks and manufacturing processes due to a low temperature poly-silicon (LTPS) thin film transistor (TFT) and an oxide TFT are not in a same layer.

The embodiment of the present disclosure provides an array substrate comprising:
a base,
a first thin film transistor (TFT) disposed on the base, wherein the first TFT comprises a first active layer disposed on the base, a first gate insulating layer disposed on the base and the first active layer and covering the first active layer, and a first gate disposed on the first gate insulating layer, and
a second TFT disposed on the first gate insulating layer, wherein the second TFT comprises a second active layer disposed on the first gate insulating layer, a second gate insulating layer disposed on the second active layer, and a second gate disposed on the second gate insulating layer.

The first gate and the second active layer are made of a same material, and are integrally formed.

In the array substrate provided by the present disclosure, the base comprises a substrate, a multifunctional metal layer disposed on the substrate, and a buffer layer disposed on the substrate and the multifunctional metal layer and covering the multifunctional metal layer, the multifunctional metal layer comprises a signal sublayer disposed on the substrate, and a signal line connected parallel to the signal sublayer is disposed on the first gate insulating layer.

In the array substrate provided by the present disclosure, at least two parallel through-holes penetrating through the buffer layer and the first gate insulating layer are defined on the signal sublayer, and the signal line passes through each of the parallel through-holes in parallel with the signal sublayer.

In the array substrate provided by the present disclosure, the first gate, the first active layer, and the signal line are made of a same material, and are integrally formed.

In the array substrate provided by the present disclosure, the multifunctional metal layer further comprises a capacitor sublayer disposed on the substrate, a first capacitor electrode corresponding to the capacitor sublayer is disposed on the first gate insulating layer, an interlayer insulating layer covering the first gate insulating layer, the first gate, the second TFT, the signal line, and the first capacitor electrode is disposed on the first gate insulating layer, the first gate, the second TFT, the signal line, and the first capacitor electrode, and a second capacitor electrode corresponding to the first capacitor electrode is disposed on the interlayer insulating layer.

In the array substrate provided by the present disclosure, the first capacitor electrode and the second gate are made of a same material, and are integrally formed.

In the array substrate provided by the present disclosure, the first TFT comprises a first source/drain disposed on the interlayer insulating layer, the second TFT comprises a second source/drain disposed on the interlayer insulating layer, and the first source/drain, the second source/drain, and the second capacitor electrode are made of a same material and are integrally formed.

In the array substrate provided by the present disclosure, the second active layer is indium gallium zinc oxide (IGZO).

The present disclosure further provides a manufacturing method of the array substrate comprising steps:
providing a base;
forming a first TFT on the base, wherein the first TFT comprises a first active layer formed on the base, a first gate insulating layer formed on the base and the first active layer and covering the first gate insulating layer of the first active layer, and a first gate formed on the first gate insulating layer; and
forming a second TFT on the first gate insulating layer, wherein the second TFT comprises a second active layer formed on the first gate insulating layer, a second gate insulating layer formed on the second active layer, and a second gate formed on the second gate insulating layer.

The first gate and the second active layer are made of a same material, and are integrally formed.

In the manufacturing method of the array substrate provided by the present disclosure, the step of providing the base comprises:
providing a substrate; and
forming a multifunctional metal layer on the substrate, forming a buffer layer covering the multifunctional metal layer on the substrate and the multifunctional metal layer, wherein the multifunctional metal layer comprises a signal sublayer formed on the substrate, a signal line connected parallel to the signal sublayer is disposed on the first gate insulating layer, at least two parallel through-holes penetrating through the buffer layer and the first gate insulating layer are defined on the signal sublayer, and the signal line passes through each of the parallel through-holes in parallel with the signal sublayer.

Advantageous effects of the present disclosure are that, in the present disclosure, the first gate of the first TFT and the second active layer of the second TFT are disposed in the same layer, are made of the same material, and use an integrally formed method. The first gate and the second active layer are formed through a photomask, while an insulating layer between the first gate and the second active layer is omitted, which can reduce the number of photomasks and processes.

### DESCRIPTION OF DRAWINGS

In order to illustrate technical solutions of the embodiments or prior art more clearly, drawings used in a description of the embodiments will be briefly described as below. Obviously, the drawings described as below are just some embodiments of the present disclosure. For those of ordinary skill in the art, under a premise of no creative labor, other drawings can also be obtained according to these drawings.
FIG. 1 is a schematic structural diagram of an array substrate in the prior art.
FIG. 2 is a schematic structural diagram of an array substrate provided by an embodiment 1 of the present disclosure.
FIG. 3 is a schematic partial structural diagram of an array substrate provided by an embodiment 2 of the present disclosure.
FIG. 4 is a schematic structural diagram of a parallel signal line on the array substrate provided by the embodiment 2 of the present disclosure.
FIG. 5 is a schematic partial structural diagram of an array substrate provided by an embodiment 3 of the present disclosure.
FIG. 6 is a schematic partial structural diagram of an array substrate provided by an embodiment 4 of the present disclosure.
FIG. 7 is schematic flowchart of a manufacturing method of an array substrate provided by an embodiment of the present disclosure.

### DETAILED DESCRIPTION OF PREFERRED EMBODIMENTS

The following description of the embodiments with reference to the appended drawings is used for illustrating specific embodiments which may be used for carrying out the present disclosure. The directional terms described by the present disclosure, such as "upper", "lower", "front", "back", "left", "right", "inner", "outer", "side", etc., are only directions by referring to the accompanying drawings. Thus, the adopted directional terms are used to describe and understand the present disclosure, but the present disclosure is not limited thereto. In figures, elements with similar structures are indicated by the same numbers.

In descriptions of the present disclosure, it should be noted that, orientations or position relationships indicated by the terms, such as "center", "longitudinal", "transverse", "length", "width", "thickness", "upper", "lower", "front", "back", "left", "right", "vertical", "horizontal", "top", "bottom", "inside", "outside", "clockwise", "counterclockwise", etc. are based on the orientations or position relationships shown in the drawings. These are only convenience for describing the present disclosure and simplifying the descriptions, and does not indicate or imply that the device or element must have a specific orientation, a structure and an operation in the specific orientation, so it cannot be understood as a limitation on the present disclosure. In addition, the terms "first" and "second" are used for describing purposes only, and cannot be understood as indicating or implying relative importance or implicitly indicating the number of technical features indicated. Thus, the features defined as "first" and "second" may explicitly or implicitly include one or more of the features. In the descriptions of the present disclosure, the meaning of "plurality" is two or more, unless it is specifically defined otherwise.

In the present disclosure, the terms "mounting", "connected", "fixed" and the like should be broadly understood unless expressly stated or limited otherwise. For example, it may be fixed connected, removably connected, or integrated; it may be mechanically connected, or an electrically connected; it may be directly connected, or indirectly connected through an intermediary; it may be a connection between two elements or an interaction between two elements. For those skilled in the art, the specific meanings of the above terms in the present disclosure may be understood based on specific situations.

In the present disclosure, unless explicitly stated and defined otherwise, the first feature may be "above" or "below" the second feature and may include direct contact between the first and second features. It may also include that the first and second features are not in direct contact but are contacted by another feature between them. Moreover, the first feature is "above" the second feature, including the first feature directly above and obliquely above the second feature, or merely indicates that the first feature is higher in level than the second feature. The first feature is "below" the second feature, including the first feature is directly below and obliquely below the second feature, or only indicates that the first feature is less horizontal than the second feature.

The following disclosure provides many different embodiments or examples for achieving different structures of the present disclosure. To simplify the present disclosure, components and settings of specific examples are described below. They are only examples and are not intended to limit the present disclosure. In addition, the present disclosure may repeat reference numbers and/or reference letters in different examples, this repetition is for the purpose of simplicity and clarity, and does not itself indicate the relationship between various embodiments and/or settings discussed. In addition, the present disclosure provides examples of various specific processes and materials, but those of ordinary skill in the art may be aware of the present disclosure of other processes and/or the use of other materials.

A technical solution of the present disclosure will now be described in conjunction with specific embodiments.

### Embodiment 1

Refer to FIG. 2, an array substrate comprises a base 10, a first thin film transistor (TFT) 101 located on a region (a) and disposed on the base, wherein the first TFT 101 comprises a first active layer 21 disposed on the base, a first gate insulating layer 22 disposed on the base 10 and the first active layer 21 and covering the first active layer 21, and a first gate 23 disposed on the first gate insulating layer 22; and a second TFT 102 located in a region (b) and disposed on the first gate insulating layer 22, wherein the second TFT 102 comprises a second active layer 31 disposed on the first gate insulating layer 22, a second gate insulating layer 32 disposed on the second active layer 31, and a second gate 33 disposed on the second gate insulating layer 32.

Wherein, the first gate 23 and the second active layer 31 are made of a same material, and are integrally formed. A material of the second active layer 31 comprises, but is not limited to, an oxide semiconductor, and may specifically be indium gallium zinc oxide (IGZO), zinc oxide (ZnO), or other materials. The first gate 23 is formed while the second active layer 31 is formed, and its forming method comprises but is not limited to following steps: firstly forming an entire surface of an oxide semiconductor film layer, then simultaneously forming the patterned first gate 23 and the patterned second active layer 31 through exposure, etching, and other processes. In some embodiments, in order to reduce a resistance value of the first gate 23 made of the oxide semiconductor, the first gate 23 can be conductorized by plasma processes, such as plasma process of N2, He, N2O, H2, etc. or a mixed gas thereof.

Refer to FIG. 2, in some embodiments, the base 10 further comprises a substrate 11, a multifunctional metal layer 12 disposed on the substrate 11, and a buffer layer 13 disposed on the substrate 11 and the multifunctional metal layer 12 and covering the multifunctional metal layer 12. The multifunctional metal layer 12 may be disposed under the first active layer 21. An orthographic projection of the multifunctional metal layer 12 perpendicular to a direction of the substrate 11 covers an orthographic projection of the first active layer 21 perpendicular to the direction of the substrate 11, while the multifunctional metal layer 12 comprises a light-shielding layer metal 121, and the light-shielding layer metal 121 is configured to block light from entering the first TFT 101 to improve characteristics of the first TFT 101. In some embodiments, the light-shielding layer metal 121 can be selectively not provided. In some embodiments, the substrate may be glass. In some embodiments, the substrate 11 may be a flexible material such as polyimide (PI). In some embodiments, the substrate 11 comprises a flexible material such as PI and a barrier layer. The barrier layer may be an inorganic material, and an arrangement of the substrate 11 is not limited herein.

In the present embodiment, the first gate of the first TFT and the second active layer of the second TFT are disposed in the same layer, are made of the same material, and use an integrally formed method. The first gate and the second active layer are formed through a photomask, while an insulating layer between the first gate and the second active layer is omitted, which can reduce the number of photomasks and processes.

### Embodiment 2

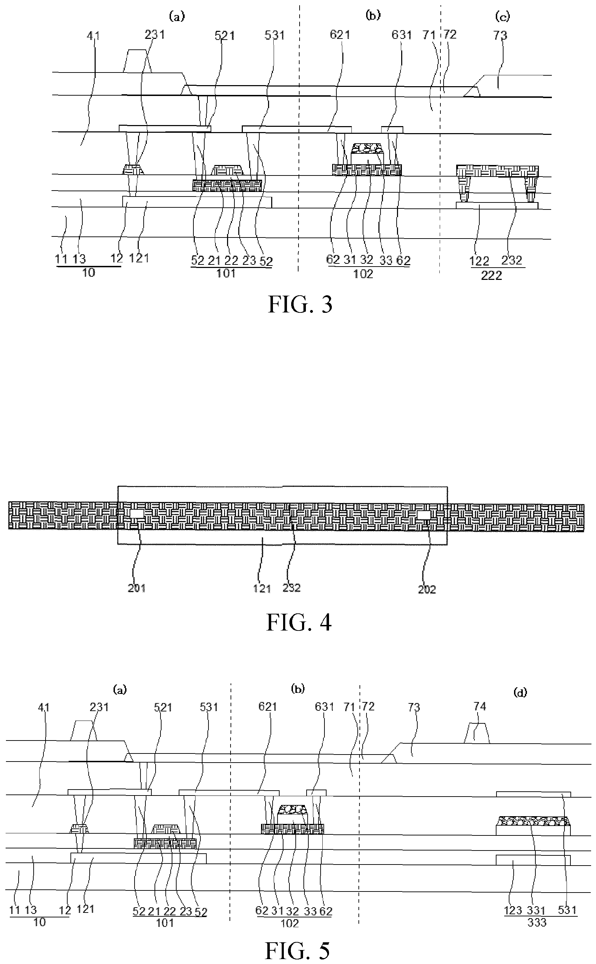

Refer to FIG. 3, the present embodiment is the same as or similar to the embodiment 1, a difference is that:
The array substrate further comprises a signal subline 232 located in a region (c). The signal subline 232, the first gate 23, and the second active layer 31 are made of a same material, and are integrally formed. Specifically, the signal subline 232 is formed while the second active layer 31 and the first gate are formed, and its forming method comprises but is not limited to following steps: firstly forming the entire surface of the oxide semiconductor film layer, then simultaneously forming the patterned first gate 23, the patterned second active layer 31, and the patterned signal subline 232 through exposure, etching, and other processes. In some embodiments, in order to reduce resistance values of the first gate 23 and the signal subline 232 made of the oxide semiconductor, the first gate 23 and the signal subline 232 can be conductorized by the plasma processes, such as plasma process of N2, He, N2O, H2, etc. or a mixed gas thereof.

Refer to FIG. 3 and FIG. 4, furthermore, the multifunctional metal layer 12 further comprises a signal sublayer 122, at least two parallel through-holes penetrating through the buffer layer and the first gate insulating layer 22 are defined on the signal sublayer 122, and the signal line 232 passes through each of the parallel through-holes in parallel with the signal sublayer 122, which further reduces the resistance value of the signal subline 232. In adoption of such method, the signal subline 232 and the signal sublayer 122 are connected in parallel to form a parallel signal line 222.

In the present embodiment, the signal subline 232 or the parallel signal line 222 may be widely used as wirings or electrodes in the array substrate, which is not limited herein, such as scanning signal lines, light-emitting control lines, etc.

In some embodiments, In the process of conductorization, in addition to conductorizing the second active layer 31, the first gate 23 and/or the signal subline 232 may further be conductorized.

In the present embodiment, the first gate of the first TFT and the second active layer of the second TFT are disposed in the same layer, which reduces the number of photomasks and processes. Meanwhile, the signal line in the same layer as the first gate and the second active layer is provided, and the parallel signal line can further be provided, which reduces the number of processes of the signal line or saves layout space of the signal line of the array substrate.

### Embodiment 3

Refer to FIG. 5, the present embodiment is the same as or similar to the embodiment 1 and the embodiment 2, a difference is that:
The multifunctional metal layer 12 further comprises a capacitor sublayer 123 disposed on the substrate 11, a first capacitor electrode 331 corresponding to the capacitor sublayer 123 is disposed on the first gate insulating layer 22, an interlayer insulating layer 41 covering the first gate insulating layer 22, the first gate 23, the second TFT 102, and the first capacitor electrode 331 is disposed on the first gate insulating layer 22, the first gate 23, the second TFT 102, and the first capacitor electrode 331, and a second capacitor electrode 531 corresponding to the first capacitor electrode 331 is disposed on the interlayer insulating layer 41.

The first capacitor electrode 331 and the second gate 531 are made of a same material, and are integrally formed. Specifically, its forming method comprises but is not limited to following steps: firstly forming an entire surface of a coating layer of the first capacitor electrode 331 and the second gate 531, then simultaneously forming the patterned first capacitor electrode 331 and the patterned second gate 531 through exposure, etching, and other processes.

The first TFT 101 comprises a first source/drain 52 disposed on the interlayer insulating layer 41, the second TFT 102 comprises a second source/drain 62 disposed on the interlayer insulating layer 41, and the first source/drain 52, the second source/drain 62, and the second capacitor electrode 531 are made of a same material and are integrally formed. Specifically, its forming method comprises but is not limited to following steps: firstly forming an entire surface of a coating layer of the first source/drain 52, the second TFT 102, and the second capacitor electrode 531, then simultaneously forming the patterned the first source/drain 52, the patterned second TFT 102, and the patterned second capacitor electrode 531 through exposure, etching, and other processes. A capacitor formed by a three-layer structure has a high charge storage capacity, thereby maintaining a stored charge quantity within a range required by the design.

In the present embodiment, the first gate of the first TFT and the second active layer of the second TFT are disposed in the same layer, which reduces the number of photomasks and processes. At the same time, the capacitance of the three-layer capacitor electrode is disposed, which reduces the number of manufacturing processes for setting the capacitor electrode or saves layout space of the capacitor electrode of the array substrate.

### Embodiment 4

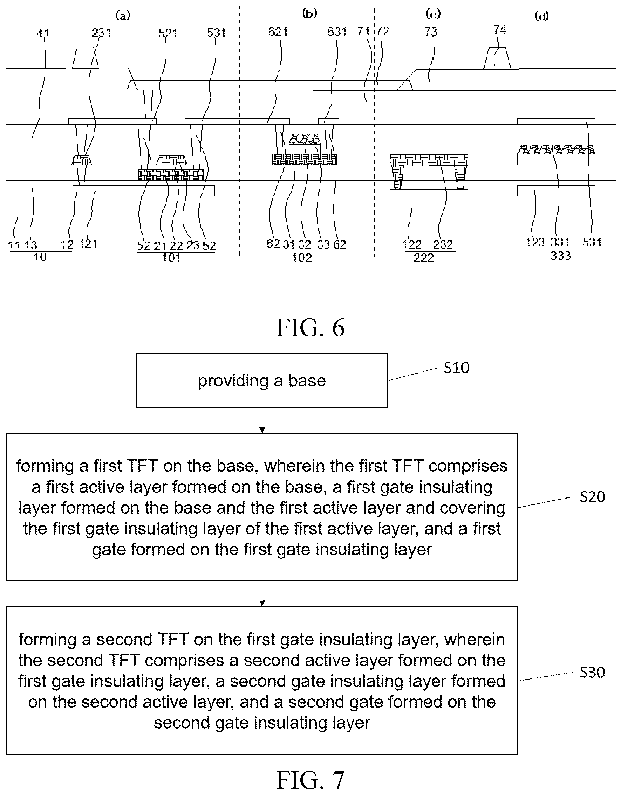

Refer to FIG. 6, the present embodiment is the same as or similar to the embodiment 1 and the embodiment 3, a difference is that:
The array substrate comprises the first TFT located in the region (a), the second TFT located in the region (b), the signal subline 232 or the parallel signal line 222 located in the region (c), and a capacitor 333 located in a region (d). The multifunctional metal layer 12 comprises the signal sublayer 122 and the capacitor sublayer 123. Moreover, the multifunctional metal layer 12 further comprises the light-shielding layer metal 121. Wherein, the first gate 23 and the second active layer 31 are made of a same material, and are integrally formed. The first capacitor electrode 331 and the second gate 33 are made of a same material, and are integrally formed. The second source/drain 52, and the second capacitor electrode 62, and the second capacitor electrode 531 are made of a same material and are integrally formed.

In the present embodiment, the first gate of the first TFT and the second active layer of the second TFT are disposed in the same layer, which reduces the number of photomasks and processes. Meanwhile, the signal line or the parallel signal line on the same layer as the first gate and the second active layer and the capacitance of the three-layer capacitor electrode are provided, which reduce the number of manufacturing processes for setting the capacitor electrode or saves layout space of the capacitor electrode of the array substrate.

In the embodiment 1 to the embodiment 4, the material of the second active layer 31 of the second TFT 102 comprises, but is not limited to, an oxide semiconductor material. When the second active layer is the oxide semiconductor material, the second active layer may specifically be indium gallium zinc oxide (IGZO) or zinc oxide (ZnO), etc. The material of the first active layer 21 of the first TFT 101 comprises, but is not limited to, monocrystalline silicon (a-Si) and polycrystalline silicon (Poly-Si).

In the embodiment 1 to the embodiment 4, when the array substrate comprises the first TFT located in the region (a) and the second TFT located in the region (b), the array substrate optionally comprises the signal subline 232 or the parallel signal line 222 located in the region (c) and the capacitor 333 located in the region (d). Wherein, the region (a), the region (b), the region (c), and the region (d) can be optionally located in a display region of the array substrate at the same time or in the non-display region of the array substrate at the same time, which is not limited herein. In the present embodiment, when the array substrate is applied in organic light-emitting diode (OLED) display devices, the region (a), the region (b), the region (c), and the region (d) can be applied in pixel driving circuits, the first TFT 101 can be applied in driving TFTs of the pixel driving circuits, the second TFT 102 can be applied in switch TFTs of the pixel driving circuits, the signal subline 212 or the parallel signal line 222 can be scanning signal lines and light-emitting control lines, and the capacitor 333 may be storage capacitors of the pixel driving circuits.

In the embodiment 1 to the embodiment 4, when the array substrate is applied in the OLED display devices, the array substrate further comprises a planarization layer 71 disposed on the interlayer insulating layer 41, the first source/drain 52, the second source/drain 62, and the second capacitor electrode 531 and covering the interlayer insulating layer 41, the first source/drain 52, the second source/drain 62, and the second capacitor electrode 531, an anode (a pixel electrode) 72 disposed on the planarization layer 71, and a pixel defining layer 73 disposed on the planarization layer 71 and the anode 72.

In the embodiment 1 to the embodiment 4, an inorganic insulating layer is further disposed on the interlayer insulating layer 41, the first source/drain 52, the second source/drain 62, and the second capacitor electrode 531 and covering the interlayer insulating layer 41, the first source/drain 52, the second source/drain 62, and the second capacitor electrode 531, then the inorganic insulating layer is disposed on the planarization layer 71, which is not limited herein.

In the embodiment 1 to the embodiment 4, in order to reduce resistance values of the parallel signal line or the electrode to prevent an influence of IR drop on electrical signals, multifunctional materials can use low-resistance materials or structures, such as Mo, Ti/Al/Ti, and other materials and structures, which are not limited herein.

In the embodiment 1 to the embodiment 4, when the first active layer is polysilicon (poly-Si) and the second active layer is IGZO, an array substrate structure provided by the embodiment of the present disclosure is a structure of a low temperature polycrystalline oxide (LTPO) array substrate, which can effectively reduce a number of LTPO film layers and reduce production cost of LTPO. At the same time, IGZO is proposed as a wiring solution through a conductorization and a wiring design of IGZO.

The embodiment of the present disclosure provides a manufacturing method of the array substrate, as shown in FIG. 7, comprising steps as follows:
Step S10: providing a base 10.
Step S20: forming a first TFT 101 on the base 10, wherein the first TFT 101 comprises a first active layer 21 formed on the base 10, a first gate insulating layer 22 formed on the base 10 and the first active layer 21 and covering the first gate insulating layer 22 of the first active layer 21, and a first gate 23 formed on the first gate insulating layer 22.
Step S30: forming a second TFT 102 on the first gate insulating layer 22, wherein the second TFT 102 comprises a second active layer 31 formed on the first gate insulating layer 22, a second gate insulating layer 32 formed on the second active layer 31, and a second gate 33 formed on the second gate insulating layer 32.

The first gate 23 and the second active layer 31 are made of a same material, and are integrally formed.

In the manufacturing method of the present disclosure, the first gate 23 of the first TFT 101 and the second active layer 31 of the second TFT 102 are disposed in the same layer, are made of the same material, and use an integrally formed method. The first gate 23 and the second active layer 31 are formed through a photomask, while an insulating layer between the first gate 23 and the second active layer 31 is omitted, which can reduce the number of photomasks and processes.

The following embodiments further illustrate the present disclosure.

### Embodiment 5

Firstly, providing a base 10.

Secondly, forming a first active layer 21 of a first TFT 101 on the base 10.

Thirdly, forming a first gate insulating layer 22 of the first active layer 21 on the base 10 and the first active layer 21.

Fourthly, forming second active layer of a second TFT 102 and a first gate 23 on the first gate insulating layer 22, wherein the first gate 23 and the second active layer 31 are made of a same material, and are integrally formed.

Fifthly, forming a second insulating layer 32 on the second active layer 31.

Sixthly, forming a second gate 33 on the second insulating layer 32.

Wherein, the second active layer 31 comprises, but is not limited to, an oxide semiconductor, and specifically may be made of indium gallium zinc oxide (IGZO) or zinc oxide (ZnO). The first gate 23 is formed. Meanwhile, the second active layer 31 is formed. The forming method comprises but not limited to that firstly forming an entire surface of an oxide semiconductor film layer, then simultaneously forming the patterned first gate 23 and the second active layer 31 by processes such as exposure and etching. In some embodiments, in order to reduce resistance values of the first gate 23 made of the oxide semiconductor, the first gate 23 can be conductorized by the plasma processes, such as plasma process of N2, He, N2O, H2, etc. or a mixed gas thereof.

In some embodiments, a signal sub-line 232 is further provided. The signal sub-line 232, the first gate 23, and the second active layer 31 are made of a same material, and are integrally formed. The signal sub-line 232 can be may be widely used as wirings or electrodes in the array substrate, which is not limited herein, such as scanning signal lines, light-emitting control lines, etc. in the array substrate.

In the manufacturing method of the present embodiment, the first gate 23 of the first TFT 101 and the second active layer 31 of the second TFT 102 are disposed in the same layer, are made of the same material, and use an integrally formed method. The first gate 23 and the second active layer 31 are formed through a photomask, while an insulating layer between the first gate 23 and the second active layer 31 is omitted, which can reduce the number of photomasks and processes. Meanwhile, the second gate insulating layer 32 and the second gate 33 may be integrally formed by a same etching process, which is not be described herein.

### Embodiment 6

The step of providing the base 10 comprises:
Firstly, providing a substrate 11.
Secondly, forming a multifunctional metal layer 12 on the substrate 11.
Thirdly, forming a buffer layer 13 covering the multifunctional metal layer 12 on the substrate 11 and the multifunctional metal layer 12.

In some embodiments, the substrate may be glass. In some embodiments, the substrate 11 may be a flexible material such as polyimide (PI). In some embodiments, the substrate 11 comprises a flexible material such as PI and a barrier layer. The barrier layer may be an inorganic material, and an arrangement of the substrate 11 is not limited herein.

In some embodiments, the multifunctional metal layer 12 may be optionally one or more of the light-shielding layer metal 121, the signal sublayer 122, and the capacitor sublayer 123. In some embodiments, the multifunctional metal layer 12 may be disposed under the first active layer 21. An orthographic projection of the multifunctional metal layer 12 perpendicular to a direction of the substrate 11 covers an orthographic projection of the first active layer 21 perpendicular to the direction of the substrate 11, and the light-shielding layer metal 121 is configured to block light from entering the first TFT 101 to improve characteristics of the first TFT 101.

In some embodiments, at least two parallel through-holes penetrating through the buffer layer 13 and the first gate insulating layer 22 are defined on the signal sublayer 122, and the signal subline 232 passes through each of the parallel through-holes in parallel with the signal sublayer 122, which further reduces the resistance value of the signal subline 232. In adoption of such method, the signal subline 232 and the signal sublayer 122 are connected in parallel to form a parallel signal line 222. In some embodiments, when the multifunctional metal layer 12 is a capacitor sublayer 123, the first gate insulating layer 22 is provided with the first capacitor electrode 331 corresponding to the capacitor sublayer 123. An interlayer insulating layer 41 covering the first gate insulating layer 22, the first gate 23, the second TFT 102, and the first capacitor electrode 331 is disposed on the first gate insulating layer 22, the first gate 23, the second TFT 102, and the first capacitor electrode 331, and a second capacitor electrode 531 corresponding to the first capacitor electrode 331 is disposed on the interlayer insulating layer 41. A capacitor formed by a three-layer structure has a high charge storage capacity, thereby maintaining a stored charge quantity within a range required by the design.

In the embodiment 5 and the embodiment 6, when the first active layer 21 is polysilicon (poly-Si) and the second active layer 31 is IGZO, the manufacturing method of the array substrate provided by the embodiment of the present disclosure is an LTPO array substrate manufacturing method, which can effectively reduce a number of LTPO film layers and reduce production cost of LTPO. At the same time, IGZO is proposed as a wiring solution through a conductorization and a wiring design of IGZO.

In the manufacturing method of the present embodiment, the first gate 23 of the first TFT 101 and the second active layer 31 of the second TFT 102 are disposed in the same layer, which can reduce the number of photomasks and processes. Moreover, a base 10 is provided, the base 10 comprises the multifunctional metal layer 12, and the multifunctional metal layer 12 can be optionally one or more of the light-shielding layer metal 121, the signal sublayer 122, and the capacitor sublayer 123, which reduces the number of manufacturing processes for setting the signal lines and the electrode, and saves layout space of the signal lines and the electrode of the array substrate.

In summary, although the present disclosure has been disclosed as above in preferred embodiments, the above-mentioned preferred embodiments are not intended to limit the present disclosure. Those of ordinary skill in the art can make various changes and modifications without departing from the spirit and scope of the present invention. Therefore, a protection scope of the present disclosure is subject to the scope defined by the claims.

## Claims

1. An array substrate, comprising:
a base;
a first thin film transistor (TFT) disposed on the base, wherein the first TFT comprises a first active layer disposed on the base, a first gate insulating layer disposed on the base and the first active layer and covering the first active layer, and a first gate disposed on the first gate insulating layer; and
a second TFT disposed on the first gate insulating layer, wherein the second TFT comprises a second active layer disposed on the first gate insulating layer, a second gate insulating layer disposed on the second active layer, and a second gate disposed on the second gate insulating layer;
wherein the first gate and the second active layer are made of a same material, and are integrally formed.

2. The array substrate as claimed in claim 1, wherein the base comprises a substrate, a multifunctional metal layer disposed on the substrate, and a buffer layer disposed on the substrate and the multifunctional metal layer and covering the multifunctional metal layer, the multifunctional metal layer comprises a signal sublayer disposed on the substrate, and a signal line connected parallel to the signal sublayer is disposed on the first gate insulating layer.

3. The array substrate as claimed in claim 2, wherein at least two parallel through-holes penetrating through the buffer layer and the first gate insulating layer are defined on the signal sublayer, and the signal line passes through each of the parallel through-holes in parallel with the signal sublayer.

4. The array substrate as claimed in claim 3, wherein the first gate, the first active layer, and the signal line are made of a same material, and are integrally formed.

5. The array substrate as claimed in claim 2, wherein the multifunctional metal layer comprises a capacitor sublayer disposed on the substrate, a first capacitor electrode corresponding to the capacitor sublayer is disposed on the first gate insulating layer, an interlayer insulating layer covering the first gate insulating layer, the first gate, the second TFT, the signal line, and the first capacitor electrode is disposed on the first gate insulating layer, the first gate, the second TFT, the signal line, and the first capacitor electrode, and a second capacitor electrode corresponding to the first capacitor electrode is disposed on the interlayer insulating layer.

6. The array substrate as claimed in claim 5, wherein the first capacitor electrode and the second gate are made of a same material, and are integrally formed.

7. The array substrate as claimed in claim 5, wherein the first TFT comprises a first source/drain disposed on the interlayer insulating layer, the second TFT comprises a second source/drain disposed on the interlayer insulating layer, and the first source/drain, the second source/drain, and the second capacitor electrode are made of a same material and are integrally formed.

8. The array substrate as claimed in claim 5, wherein the second active layer is indium gallium zinc oxide (IGZO).

9. An array substrate, comprising:
a base;
a first thin film transistor (TFT) disposed on the base, wherein the first TFT comprises a first active layer disposed on the base, a first gate insulating layer disposed on the base and the first active layer and covering the first active layer, and a first gate disposed on the first gate insulating layer; and
a second TFT disposed on the first gate insulating layer, wherein the second TFT comprises a second active layer disposed on the first gate insulating layer, a second gate insulating layer disposed on the second active layer, and a second gate disposed on the second gate insulating layer;
wherein the first gate and the second active layer are made of a same material, and are integrally formed;
the base comprises a substrate, a multifunctional metal layer disposed on the substrate, and a buffer layer disposed on the substrate and the multifunctional metal layer and covering the multifunctional metal layer, the multifunctional metal layer comprises a signal sublayer disposed on the substrate, and a signal line connected parallel to the signal sublayer is disposed on the first gate insulating layer;
at least two parallel through-holes penetrating through the buffer layer and the first gate insulating layer are defined on the signal sublayer, and the signal line passes through each of the parallel through-holes in parallel with the signal sublayer; and
the multifunctional metal layer further comprises a capacitor sublayer disposed on the substrate, a first capacitor electrode corresponding to the capacitor sublayer is disposed on the first gate insulating layer, an interlayer insulating layer covering the first gate insulating layer, the first gate, the second TFT, the signal line, and the first capacitor electrode is disposed on the first gate insulating layer, the first gate, the second TFT, the signal line, and the first capacitor electrode, and a second capacitor electrode corresponding to the first capacitor electrode is disposed on the interlayer insulating layer.

10. The array substrate as claimed in claim 9, wherein the first gate, the first active layer, and the signal line are made of a same material, and are integrally formed.

11. The array substrate as claimed in claim 9, wherein the first capacitor electrode and the second capacitor electrode are made of a same material, and are integrally formed.

12. The array substrate as claimed in claim 9, wherein the first TFT comprises a first source/drain disposed on the interlayer insulating layer, the second TFT comprises a second source/drain disposed on the interlayer insulating layer, and the first source/drain, the second source/drain, and the second capacitor electrode are made of a same material and are integrally formed.

13. The array substrate as claimed in claim 9, wherein the second active layer is IGZO.

14. A manufacturing method of an array substrate, comprising following steps:
providing a base;
forming a first TFT on the base, wherein the first TFT comprises a first active layer formed on the base, a first gate insulating layer formed on the base and the first active layer and covering the first gate insulating layer of the first active layer, and a first gate formed on the first gate insulating layer; and
forming a second TFT on the first gate insulating layer, wherein the second TFT comprises a second active layer formed on the first gate insulating layer, a second gate insulating layer formed on the second active layer, and a second gate formed on the second gate insulating layer;
wherein the first gate and the second active layer are made of a same material, and are integrally formed.

15. The manufacturing method of the array substrate as claimed in claim 14, wherein the step of providing the base comprises:
providing a substrate; and
forming a multifunctional metal layer on the substrate, forming a buffer layer covering the multifunctional metal layer on the substrate and the multifunctional metal layer, wherein the multifunctional metal layer comprises a signal sublayer formed on the substrate, a signal line connected parallel to the signal sublayer is disposed on the first gate insulating layer, at least two parallel through-holes penetrating through the buffer layer and the first gate insulating layer are defined on the signal sublayer, and the signal line passes through each of the parallel through-holes in parallel with the signal sublayer.
